Europäisches Patentamt

European Patent Office

Office européen des brevets

(11) Veröffentlichungsnummer: **0 262 430**
**A1**

## (12) EUROPÄISCHE PATENTANMELDUNG

(21) Anmeldenummer: **87112761.9**

(22) Anmeldetag: **02.09.87**

(51) Int. Cl.⁴: **G01R 15/07 , H01F 40/02**

(30) Priorität: **29.09.86 CH 3896/86**

(43) Veröffentlichungstag der Anmeldung:
**06.04.88 Patentblatt 88/14**

(84) Benannte Vertragsstaaten:
**CH DE FR GB LI SE**

(71) Anmelder: **BBC Brown Boveri AG**

**CH-5401 Baden(CH)**

(72) Erfinder: **Maschek, Martin**
**Florastrasse 33**
**CH-8116 Würenlos(CH)**
Erfinder: **Mastner, Georg**
**Loonstrasse 5**
**CH-5443 Niederrohrdorf(CH)**

(54) **Stromwandleranordnung für Hochspannungsfreiluftanlagen.**

(57) Zur Erhöhung der Verfügbarkeit von Stromwandlern für Hochspannungsfreiluftanlagen wird ein elektronisches Signalverarbeitungsgerät (13, 16) für das Messignal des Stromwandlers (25) innerhalb eines aussen lackierten Wandlerkopfgehäuses (1) als von oben ausbaubarer Block (12, 13, 15, 16) oberhalb des Stromwandlers angeordnet. Das elektronische Signalverarbeitungsgerät (13, 16) ist an einer parallel zu einem Primärleiter (22) ausgerichteten Abdeckplatte (12) eines magnetischen Abschirmgehäuses (11) befestigt, welches von einem elektrischen Abschirmgehäuse (8) umgeben ist. Das Signalverarbeitungsgerät besteht aus einer Schwachstromelektronik (13) unterhalb und einer Leistungselektronik (16) oberhalb der Abdeckplatte (12); sie wandelt Analogsignale des Stromwandlers (25) in digitalisierte und kodierte Signale für eine serielle Uebertragung mittels einer Lichtfaserleitung (27) um. Die Leistungselektronik (16) steht über eine Metallplatte (15) in gut wärmeleitendem Kontakt mit der Abdeckplatte (10) des elektrischen Abschirmgehäuses (8). Am Wandlerkopfgehäuse (1) sind untere und obere Lüftungsschlitze (2, 3) angebracht. Zwischen Wandlerkopfgehäuse (1) und elektrischem Abschirmgehäuse (8) befinden sich im Abstand von 3 cm Strahlungsreflektoren (17-19) aus poliertem und entfettetem Aluminium, um eine Temperaturerhöhung infolge Sonnenbestrahlung niedrig zu halten.

## Stromwandleranordnung für Hochspannungsfreiluftanlagen

Technisches Gebiet

Bei der Erfindung wird ausgegangen von einer Stromwandleranordnung für Hochspannungsfreiluftanlagen nach dem Oberbegriff des Patentanspruchs 1.

Stand der Technik

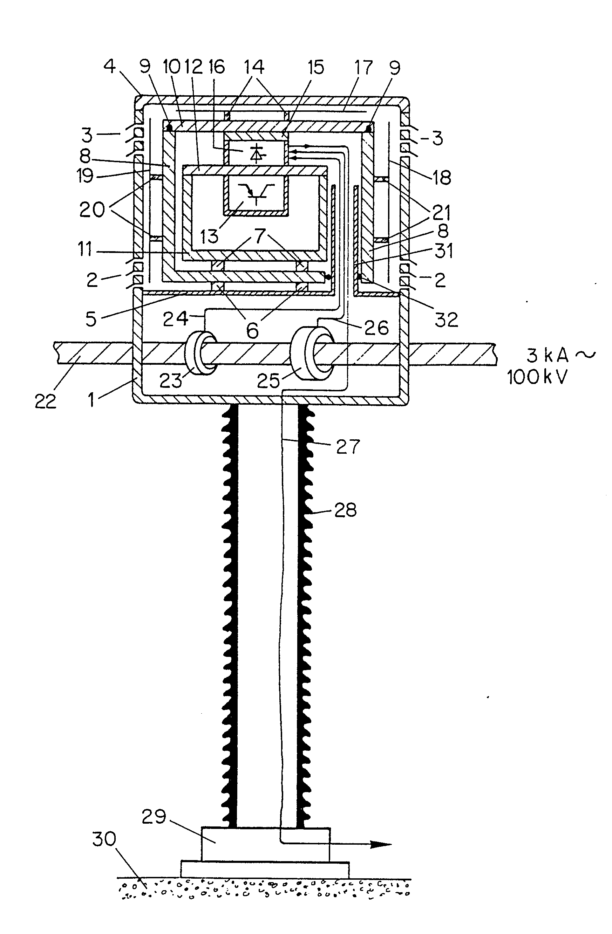

Mit dem Oberbegriff nimmt die Erfindung auf einen Stand der Technik von Stromwandleranordnungen für Hochspannungsfreiluftanlagen Bezug, wie er aus dem Bericht "Electronic Current Transducer for EHV Circuits", EL-1611, Research Project 560-1, S. 1-2, 1-3 und Fig. 5-3, Final Report, November 1980, Westinghouse Electric Corporation, Forbes Road, Trafford, Pennsylvania 15085, USA, bekannt ist. Dort ist die elektronische Auswerteinrichtung für das Messignal des Stromwandlers unterhalb des Stromwandlers angeordnet und durch einen Hochspannungsisolator gestützt. In der Auswerteinrichtung wird das Sekundärstromsignal von mindestens einem transformatorartigen Stromwandler skaliert, digitalisiert und kodiert. Die digitalisierten Messwerte werden über eine optische Faser im Innern des Hochspannungsisolators auf Erdpotential und dann in einen Steuerraum übertragen, wo sie ausgewertet werden. Zur Energieversorgung der elektronischen Auswerteinrichtung wird ein Hilfstransformator verwendet, der die Versorgungsenergie vom Leitungsstrom ableitet.

Nachteilig dabei ist die schwere Zugänglichkeit der Elektronik in unmittelbarer Nähe der Hochspannungsleitung bei einer Reparatur, die bis zu 8 h dauern kann und in Abständen von 3 a - 6 a zu erwarten ist.

Darstellung der Erfindung

Die Erfindung, wie sie im Patentanspruch 1 definiert ist, löst die Aufgabe, eine Stromwandleranordnung für Hochspannungsfreiluftanlagen anzugeben, die eine höhere Verfügbarkeit und damit einen geringeren Ausfall aufweist.

Ein Vorteil der Erfindung besteht darin, dass eine schnellere Reparatur des elektronischen Stromwandlers möglich ist, ohne dass dieser nach der Reparatur nochmals eingemessen werden müsste. Die Messwertverarbeitungselektronik als solche ist justiert und kalibriert, so dass ein Kalibrieren des ganzen elektronischen Wandlers (Stromwandler, Elektronik, Messwertübertragung, Auswertung) nach dem Ersatz der defekten Elektronik durch eine neue entfallen kann. Dabei ist es von Vorteil, wenn der Shunt bzw. die Bürde des Stromwandlers (Transformators) in die Elektronik integriert ist, da dann die ganze im Wandlerkopf plazierte Elektronik als Einheit plombiert werden kann. Damit lassen sich Reparaturen innerhalb 1 h ausführen.

Ein Vorteil der Erfindung gemäss Anspruch 2 besteht darin, dass die Elektronik als kompakter Monoblock ausgeführt ist, dessen einzige Verbindung nach aussen nur aus den Anschlüssen an passive Komponenten des Wandlerkopfes besteht, typisch aus den Anschlüssen an den oder die Stromwandler, den Anschlüssen an die Energieversorgung der Elektronik und dem Anschluss an den Lichtleiter.

Gemäss Anspruch 3 ergibt sich der Vorteil, dass bei der Demontage der Elektronik keine anderen Funktionsblöcke oder Teile davon (Primärleiter, Stromwandler, Lichtleiterführung, Befestigung am Isolator) entfernt werden müssen, um zu der Elektronik selbst zu gelangen.

Das topfförmige erste Abschirmgehäuse aus einem magnetisch abschirmenden Material mit einer Abdeckplatte parallel zum Primärleiter gemäss Anspruch 4 gewährleisten eine gute magnetische Abschirmung der Elektronik von den vom Primärleiter ausgehenden Magnetfeldern.

Eine zusätzliche elektromagnetische Abschirmung wird durch das zweite Abschirmgehäuse gemäss Anspruch 5 und die Leitungsführung gemäss Anspruch 6 erreicht.

Die von der Leistungselektronik erzeugte Wärme wird gemäss Anspruch 7 mittels einer Metallplatte über die Abdeckplatte des ersten Abschirmgehäuses grossflächig an die umgebende Luft abgeführt, so dass die elektronischen Bauelemente gut gekühlt sind und eine längere Lebensdauer aufweisen.

Aufheizungen des Wandlerkopfes durch Sonnenbestrahlung werden durch Anordnung von Strahlungsreflektoren innerhalb des Wandlerkopfgehäuses gemäss den Ansprüchen 8 und 9 gering gehalten.

Besonders vorteilhaft ist es, die Oberfläche der Strahlungsreflektoren gemäss Anspruch 10 aus poliertem Aluminium auszubilden, wodurch Wärmestrahlung von der Elektronik ferngehalten wird.

## Kurze Beschreibung der Zeichnung

Die Erfindung wird nachstehend anhand eines Ausführungsbeispiels erläutert. Die einzige Figur zeigt eine Stromwandleranordnung für eine Hochspannungsfreiluftanlage teilweise im Schnitt.

## Weg zur Ausführung der Erfindung

Ein Wandlerkopfgehäuse 1 aus einem rostfreien Blech, das einen nach oben abnehmbaren Deckel 4 aufweist, ist am oberen Ende eines hohlen Hochspannungsisolators 28 befestigt. Der Deckel braucht zur besseren Belüftung nicht hermetisch dicht angebracht zu sein. Der Hochspannungsisolator 28 ist auf einem Sockel 29 montiert, der auf einem ebenen Boden 30 steht.

Ein Stromleiter bzw. Primärleiter 22 für einen Nennstrom von 3 kA und eine Nennwechselspannung von 400 kV ist durch das Wandlerkopfgehäuse 1 geführt und innerhalb des unteren Teils dieses Wandlerkopfgehäuses von einem ringförmigen Primär-bzw. Stromwandler 25 und einem ringförmigen Stromversorgungstransformator 23 umgeben.

Der untere Teil des Wandlerkopfgehäuses 1 ist durch eine Trennwand 5 aus korrosionsbeständigem Blech von einem oberen Teil, in dem ein elektronisches Signalverarbeitungsgerät bzw. die Elektronik für das Messsignal des Stromwandlers untergebracht ist, getrennt. Der obere Teil des Wandlerkopfgehäuses 1 weist dicht oberhalb der Trennwand 5 untere Lüftungsschlitze 2 und dicht unterhalb des Deckels 4 obere Lüftungsschlitze 3 auf. Die Lüftungsschlitze 2 und 3 sind durch an der Aussenseite des Wandlerkopfgehäuses 1 vorragende Abschrägungen gegen direkten Regen geschützt.

Oberhalb der Trennwand 5 ist ein topfförmiges, elektrisches Abschirmgehäuse 8 aus 6 mm dickem Aluminiumblech mittels Schrauben bzw. Stützen 6 an der Trennwand 5 befestigt. Das Abschirmgehäuse 8 weist einen nach oben abnehmbaren Deckel bzw. eine Abdeckplatte 10 parallel zum Primärleiter 22 auf, in die in der Auflagefläche eine Gummidichtung 9 gegen Spritzwasser eingelassen ist.

An den Seitenwänden des Abschirmgehäuses 8 sowie an der Abdeckplatte 10 sind mittels Schrauben bzw. Stützen 20, 21 und 14 Strahlungsreflektoren 19, 18 und 17 aus ca. 1 mm dickem Aluminiumblech befestigt, welches beidseitig poliert und entfettet ist. Der Abstand der Strahlungsreflektoren 17 - 19 von den Seitenwänden des Abschirmgehäuses 8, von der Abdeckplatte 10 und von den Innenwänden des Wandlerkopfgehäuses 1 sowie dessen Deckel 4 beträgt 3 cm. Zwischen dem oberen Strahlungs reflektoren 18 und 19 verbleibt jeweils ein Lüftungsschlitz.

Innerhalb des elektrischen Abschirmgehäuses 8 ist ein topfförmiges, magnetisches Abschirmgehäuse 11 aus Weicheisen mittels Schrauben bzw. Stützen 7 am Boden des Abschirmgehäuses 8 befestigt. Das Abschirmgehäuse 11 weist einen nach oben abnehmbaren Deckel bzw. eine Abdeckplatte 12 parallel zum Primärleiter 22 auf, an welcher Abdeckplatte die Elektronik befestigt ist. An der Unterseite der Abdeckplatte 12 ist eine nur symbolisch angedeutete Schwachstromelektronik 13 und oberhalb eine symbolisch angedeutete Leistungselektronik 16 angebracht. Die Leistungselektronik 16 steht über eine Metallplatte 15 mit der Abdeckplatte 10 in gut wärmeleitendem Kontakt, so dass die von der Leistungselektronik erzeugte Wärme schnell über diese Metallplatte 15 und die Abdeckplatte 10 an die sie umgebende Luft abgeführt wird.

Von dem Stromversorgungstransformator 23 führen Stromversorgungsleitungen 24, wovon der besseren Uebersichtlichkeit halber nur eine dargestellt ist, und vom Stromwandler 25 eine Messignalleitung 26 durch eine Oeffnung der Trennwand 5 und den Boden des elektrischen Abschirmgehäuses 8 im Zwischenraum zwischen dem elektrischen und * magnetischen Abschirmgehäuse 8 bzw. 11 zur Leistungselektronik 16. Die Messignalleitung 26 und die Stromversorgungsleitungen 24 sind längs eines Teils ihrer Strecke in einem mit der Trennwand 5 verbundenen Rohr 31 geführt, das mittels einer isolierenden Dichtung 32 gegenüber dem Boden des Abschirmgehäuses 8 abgedichtet ist. Von dem Raum der Leistungselektronik 16 führt eine Lichtfaserleitung 27 auf dem gleichen Weg durch die Oeffnung in der Trennwand 5 und dann durch den Innenhohlraum des Hochspannungsisolators 28 und einen Innenhohlraum im Sockel 29 auf Erdpotential zu einem nicht dargestellten Signalauswertraum.

Die Leitungen 24, 26 und 27 sind trennbar an der Leistungselektronik 16 befestigt. Von der Leistungselektronik 16 gehen nicht dargestellte Leitungen zur Schwachstromelektronik 13.

Falls in der Elektronik - Leistungselektronik 16 oder Schwachstromelektronik 13 - ein Fehler auftritt, werden bei abgeschalteter Hochspannung am Primärleiter 22 nacheinander die Deckel 4 und 10 nach oben entfernt. Danach werden die Leitungen 24, 26 und 27 von der Leistungselektronik 16 getrennt und die Abdeckplatte 12 mit daran befestigter Elektronik nach oben entfernt. Anschliessend wird die defekte Elektronik durch eine neue, eingemessene Elektronik ersetzt, so dass keine weitere Justierung erforderlich ist. Danach wird die Abdeckplatte 12 von oben eingesetzt und am Abschirmgehäuse 11 befestigt. Die Leiter 24, 26 und 27 werden an die Leistungselektronik 16 angeschlossen und danach die beiden Deckel 10 und 4 an den jeweiligen Gehäuseteilen 8 bzw. 1 befestigt. Auf diese Weise lässt sich die Reparatur von geübtem Wartungspersonal innerhalb 30 min, allenfalls innerhalb 60 min ausführen.

Die Ausfallrate der elektronischen Komponenten steigt mit zunehmender Temperatur steil an. Im Freien aufgestellte Elektronik muss gegen Umwelteinflüsse, wie Witterung, Vögel, Mäuse, Insekten usw., geschützt sein, was eine mechanisch gute und damit thermisch schlechte Kapselung bedingt. Um diesen Einflüssen Rechnung zu tragen und eine zusätzliche Erwärmung der Elektronik durch die Sonnenbestrahlung möglichst gering zu halten, sind die Strahlungsreflektoren 17 - 19 mit möglichst hohen Reflexionskoeffizienten für Wärmestrahlung vorgesehen. Sie gewährleisten in Verbindung mit den unteren und oberen Lüftungsschlitzen 2 und 3, mit denen eine Kaminwirkung erzielt wird, dass die durch Sonnenbestrahlung bedingte Temperaturerhöhung innerhalb des Wandlerkopfgehäuses 1 nicht mehr als etwa 1 K beträgt. Dadurch wird die Lebensdauer der elektronischen Bauelemente und damit die Betriebsbereitschaft der Stromwandleranordnung erhöht.

Statt eines Strahlungsreflektors 17 bzw. 18 bzw. 19 im Zwischenraum von elektrischem Abschirmgehäuse 8 und Wandlerkopfgehäuse 1 können auch mehrere voneinander beabstandete Strah lungsreflektoren vorgesehen sein. Der Abstand zwischen ihnen sowie der Abstand zwischen dem äusseren Strahlungsreflektor und dem Wandlerkopfgehäuse 1 sollte nicht kleiner als 5 mm sein.

Die äussere Oberfläche des Wandlerkopfgehäuses 1 ist vorzugsweise lackiert. Die innere Oberfläche des Wandlerkopfgehäuses 1 ist metallisch blank und entfettet und damit gut reflektierend ausgebildet.

Die Wechselspannungen des Primärleiters 22 liegen üblicherweise im Bereich von 50 kV bis etwa 1 MV. Spitzenströme bis 150 kA sind zulässig.

**Ansprüche**

1. Stromwandleranordnung für Hochspannungsfreiluftanlagen
   a) mit einem Primärleiter (22) und einem Stromwandler (25) zur Detektion eines durch den Primärleiter fliessenden Wechselstromes,
   b) ferner mit mindestens einem elektronischen Signalverarbeitungsgerät (13, 16) für das Messignal des Stromwandlers und
   c) mit einem Wandlerkopfgehäuse (1), in dem der Stromwandler und das elektronische Signalverarbeitungsgerät untergebracht sind,
   dadurch gekennzeichnet,
   d) dass das elektronische Signalverarbeitungsgerät (13, 16) oberhalb des Stromwandlers angeordnet ist.

2. Stromwandleranordnung nach Anspruch 1, dadurch gekennzeichnet, dass das elektronische Signalverarbeitungsgerät (13, 16) als von oben ausbaubarer Block (12, 13, 15, 16) ausgebildet ist.

3. Stromwandleranordnung nach Anspruch 1 oder 2, dadurch gekennzeichnet, dass das elektronische Signalverarbeitungsgerät (13, 16) an einem Deckel oder einer Abdeckplatte (12) eines ersten Abschirmgehäuses (11) befestigt ist.

4. Stromwandleranordnung nach Anspruch 3, dadurch gekennzeichnet,
   a) dass das erste Abschirmgehäuse (11) ein topfförmiges Gehäuseteil aus einem magnetisch abschirmenden Material aufweist und
   b) dass die Abdeckplatte (12) des ersten Abschirmgehäuses (11) parallel zum Primärleiter (22) angeordnet ist.

5. Stromwandleranordnung nach Anspruch 3 oder 4, dadurch gekennzeichnet,
   a) dass das erste Abschirmgehäuse (11) von einem zweiten Abschirmgehäuse (8) aus einem elektrisch gut leitenden Material umschlossen ist und
   b) dass das zweite Abschirmgehäuse einen nach oben herausnehmbaren Deckel oder eine Abdeckplatte (10) aufweist.

6. Stromwandleranordnung nach Anspruch 5, dadurch gekennzeichnet,
   a) dass innerhalb des Wandlerkopfgehäuses (1) am Primärleiter (22) ein ringförmiger Stromversorgungstransformator (23) zur Stromversorgung des elektronischen Signalverarbeitungsgerätes (13, 16) angeordnet ist,
   b) dass vom Stromversorgungstransformator (23) ausgehende Stromversorgungsleitungen (24) und eine vom Stromwandler (25) ausgehende Messignalleitung (26) durch den Zwischenraum von erstem und zweitem Abschirmgehäuse zum Leistungsteil (16) des elektronischen Signalverarbeitungsgerätes (13, 16) geführt und
   c) an dieses Leistungsteil trennbar angeschlossen sind.

7. Stromwandleranordnung nach Anspruch 5 oder 6, dadurch gekennzeichnet,
   a) dass der Leistungsteil (16) des elektronischen Signal-verarbeitungsgerätes (13, 16) im Zwischenraum zwischen erstem und zweitem Abschirmgehäuse angeordnet ist und
   b) mit der Abdeckplatte (10) des zweiten Abschirmgehäuses (8) in gut wärmeleitendem Kontakt steht.

8. Stromwandleranordnung nach einem der Ansprüche 1 bis 7, dadurch gekennzeichnet,

a) dass das Wandlerkopfgehäuse (1) zwischen dem Primärleiter (22) und dem elektronischen Signalverarbeitungsgerät (13, 16) eine Trennwand (5) aufweist,

b) dass am Wandlerkopfgehäuse wenigstens oberhalb und nahe dieser Trennwand untere Lüftungsschlitze (2),

c) dass wenigstens in Deckelnähe des Wandlerkopfgehäuses obere Lüftungsschlitze (3) und

d) dass zwischen dem elektronischen Signalverarbeitungsgerät (13, 16) und mindestens einer Seitenwand des Wandlerkopfgehäuses (1) in vorgebbarem Abstand zu dieser Seitenwand mindestens ein seitlicher Strahlungsreflektor (18, 19) angeordnet ist.

9. Stromwandleranordnung nach Anspruch 8, dadurch gekennzeichnet,

a) dass zwischen dem elektronischen Signalverarbeitungsgerät (13, 16) und dem Deckel (4) des Wandlerkopfgehäuses (1) in vorgebbarem Abstand zu diesem Deckel mindestens ein oberer Strahlungsreflektor (17) angeordnet ist und

b) dass zwischen diesem oberen Strahlungsreflektor und dem mindestens einen seitlichen Strahlungsreflektor (18, 19) ein Lüftungsschlitz bleibt.

10. Stromwandleranordnung nach Anspruch 9, dadurch gekennzeichnet,

a) dass der Reflexionskoeffizient jedes Strahlungsreflektors (17-19) mindestens auf seiner dem Wandlerkopfgehäuse (1) zugewandten Fläche grösser als 0,8 ist,

b) insbesondere, dass der Strahlungsreflektor mindestens eine Oberfläche aus poliertem Aluminium aufweist.

3 kA ~
100 kV

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | IEEE TRANSACTIONS ON INSTRUMENTATION AND MEASUREMENT, Band IM-22, Nr. 4, Dezember 1973, Seiten 394-399, IEEE, New York, US; A. BRAUN et al.: "Optoelectronic electricity meter for high-voltage lines" * Figur 7 * --- | 1 | G 01 R 15/07 H 01 F 40/02 |
| A | ELEKTRIE, Band 39, Nr. 3, 1985, Seiten 104-106, Ost-Berlin, DD; D. JAHN et al.: "Doppeltgeschirmter Aufbau einer Messwertübertragungseinrichtung durch Modifizierung des EGS-Systems" * Seite 106, rechte Spalte * --- | 1 | |
| A | EP-A-0 154 171 (GENERAL ELECTRIC) --- | | |
| A | DE-A-2 909 389 (DeLAVAL TURBINE) --- | | |
| A | GB-A-2 005 037 (SIEMENS) ----- | | |

**RECHERCHIERTE SACHGEBIETE (Int. Cl.4)**

G 01 R 15/00
G 01 R 1/00
H 01 F 40/00

Der vorliegende Recherchenbericht wurde für alle Patentansprüche erstellt

| Recherchenort | Abschlußdatum der Recherche | Prüfer |
|---|---|---|
| DEN HAAG | 18-12-1987 | VANHULLE R. |